# EUROPEAN PATENT SPECIFICATION

(11) **EP 3 546 961 B1**
(45) Date of publication and mention of the grant of the patent: **22.02.2023**
(21) Application number: 17888974.7
(22) Date of filing: 28.02.2017
(51) Int. Cl.: G01R 31/392, G01R 31/3835, G01R 31/52

(54) **BATTERY LEAKAGE CURRENT DETECTION METHOD, DEVICE AND CIRCUIT**
VERFAHREN ZUR BATTERIELECKSTROMBESTIMMUNG, VORRICHTUNG UND SCHALTUNG
PROCÉDÉ DE DÉTECTION DE COURANT DE FUITE DE BATTERIE, DISPOSITIF ET CIRCUIT

(30) Priority: 30.12.2016 CN 201611264805
(43) Date of publication of application: 02.10.2019
(73) Proprietor: Huawei Technologies Co., Ltd., Longgang District Shenzhen, Guangdong 518129 (CN)
(72) Inventor: YU, Wenchao, Shenzhen Guangdong 518129 (CN); WEN, Chong, Shenzhen Guangdong 518129 (CN); WANG, Hui, Shenzhen Guangdong 518129 (CN); XU, Jianjun, Shenzhen Guangdong 518129 (CN); CHAO, Kangjie, Shenzhen Guangdong 518129 (CN); KUANG, Huogen, Shenzhen Guangdong 518129 (CN)
(74) Representative: Goddar, Heinz J.
(86) International application number: PCT/CN2017/075197
(87) International publication number: WO 2018/120407

(56) References cited:
- CN-A- 101 782 628
- CN-A- 103 403 941
- JP-A- 2009 252 459
- JP-A- 2015 072 148
- US-A1- 2009 099 799
- US-A1- 2016 103 188
- US-A1- 2016 377 667
- US-B2- 6 563 318

## Description

### TECHNICAL FIELD

This application relates to the battery field, and in particular, to a battery leakage current check method, apparatus, and circuit.

### BACKGROUND

Currently, battery safety has become an important factor that affects safety of an electronic device such as a mobile phone, and the battery safety has become a focus of mobile phone manufacturers. In the prior art, battery over-charge, over-discharge, over-temperature, and the like are checked by detecting a charging/discharging voltage, a charging/discharging current, and the like of a battery. However, there is hardly any proper solution for checking for a leakage current inside the battery.
US 2009/099799 A1 discloses various systems and methods for determining micro-shorts based on rate of change of state of charge.
US 6,563,318 B2 discloses a detecting method for detecting an internal state of an inspective rechargeable battery, said internal state including a deterioration state, an electricity storable capacity, a remaining capacity, and an internal resistance of said inspective rechargeable battery.
US 2016/377667 A1 discloses a method for detecting a short circuit within an energy store. The method includes registering a current which flows through the energy store, registering a first voltage which is made available by the energy store at a first time, registering a second voltage which is made available by the energy store at a second time following the first time, and determining whether a short circuit is present based on the first and second voltage.
US 2016/103188 A1 discloses a method for monitoring the state of a battery, in which method a battery with an internal short-circuit is identified by an alarm signal of an evaluation unit when the battery current does not fall after the battery has been charged over a long time period, or when the no-load voltage or discharge voltage of the battery drops or rapidly drops after a relatively long charging operation.

### SUMMARY

This application provides a battery leakage current check method and apparatus in the independent claims, so as to check for a leakage current inside a battery.

Possible implementation manners are disclosed in the dependent claims. Embodiments which do not fall within the scope of the claims are examples for understanding the present invention.

According to a first aspect, some embodiment of this application provides a battery leakage current check method, wherein a battery is installed in an electronic device and is configured to supply power to the electronic device, and the method comprises: controlling the battery to stop supplying power to the electronic device when a power adapter supplies power to the electronic device; obtaining a voltage parameter and a time duration parameter, wherein the voltage parameter is a difference between voltages of the battery at two different time moments, and the time duration parameter is a duration between the two different time moments; and then determining, based on the voltage parameter and the time duration parameter, whether a leakage parameter of the battery meets a preset condition. According to the battery leakage current check method provided in this embodiment of this application, when the battery stops supplying external power, it is determined, based on a voltage drop between a positive electrode and a negative electrode of the battery after a time period and the time period, whether the leakage parameter of the battery meets the preset condition, to check for a leakage current in the battery and prevent the battery from being faulty, for example, catching fire, due to an excessively high leakage current.

The determining, based on the voltage parameter and the time duration parameter, whether a leakage parameter of the battery meets a preset condition comprises: determining whether a ratio of the voltage parameter to the time duration parameter is less than a preset threshold; and determining that the leakage parameter of the battery meets the preset condition when the ratio of the voltage parameter to the time duration parameter is less than the preset threshold. The design provides a manner of determining whether the leakage parameter of the battery meets the preset condition.

In a possible design, the method further includes: controlling the batter to supply power to the electronic device when the power adapter stops supplying power to the electronic device. The design provides uninterrupted power supply to the electronic device.

In a possible design, the method further includes: outputting prompt information when determining that the leakage parameter of the battery does not meet the preset condition. According to the design, it is convenient to prompt a user in time that the battery may be faulty, so as to ensure use safety by avoiding a fault such as battery fire.

In a possible design, the prompt information includes at least one of the following information: sound information, text information, image information, vibration information, or light information. The design specifically discloses a possible implementation of the prompt information.

In a possible design, the method further includes: sending the leakage parameter to a server when determining that the leakage parameter of the battery does not meet the preset condition. According to the design, it may be convenient for a manufacturer of the electronic device to collect fault information of the electronic device, so as to analyze a fault cause and improve product performance.

In a possible design, when the power adapter stops supplying power to the electronic device, battery leakage current check may be stopped or continue. The design provides a more flexible condition for ending the battery leakage current check.

In a possible design, a condition for triggering the battery leakage current check method includes but is not limited to: after battery charging is completed and the battery is full of electricity, or during battery charging; when it is determined that the electronic device enters a standby state if a user has no operation at a current time or for a long time; when the power adapter is connected to the electronic device and supplies power to the electronic device; when a user enters, by using a user interface (user interface, UI), a command to start to perform battery leakage current check; or at periodic intervals, such as a week, a month, or a year. The design provides a more flexible opportunity of starting to perform battery leakage current check.

According to a second aspect, some embodiment of this application provides a battery leakage current check apparatus as defined in independent claim 6.

According to the battery leakage current check apparatus provided in this embodiment of this application, when the battery stops supplying external power, it is determined, based on a voltage drop between a positive electrode and a negative electrode of the battery after a time period and the time period, whether the leakage parameter of the battery meets the preset condition, to check for a leakage current in the battery and prevent the battery from being faulty, for example, catching fire, due to an excessively high leakage current. Based on a same inventive concept, for a principle in which the apparatus resolves a problem and a beneficial effect, refer to the first aspect, the possible method implementations of the first aspect, and the brought beneficial effects. Therefore, for implementation of the apparatus, refer to the first aspect and the possible method implementations of the first aspect. Details are not repeatedly described herein.

According to a third fifth aspect, some embodiment of this application provides a computer program product as defined in independent claim 11.

### BRIEF DESCRIPTION OF DRAWINGS

To describe the technical solutions in the embodiments of this application more clearly, the following briefly describes the accompanying drawings required for describing the embodiments or the prior art.
FIG. 1 is a schematic structural diagram of an electronic device according to some embodiment of this application;
FIG. 2 is a schematic structural diagram of a battery leakage current check circuit according to some embodiment of this application;
FIG. 3 is a schematic structural diagram of another battery leakage current check circuit according to some embodiment of this application;
FIG. 4 is a schematic structural diagram of still another battery leakage current check circuit according to some embodiment of this application;
FIG. 5 is a schematic structural diagram of a battery leakage current check circuit in which a battery supplies power to load according to some embodiment of this application;
FIG. 6 is a schematic flowchart of a battery leakage current check method according to some embodiment of this application;
FIG. 7 is a schematic structural diagram of a battery leakage current check circuit for battery leakage current check according to some embodiment of this application;
FIG. 8 is a schematic flowchart of another battery leakage current check method according to some embodiment of this application;
FIG. 9 is a schematic flowchart of still another battery leakage current check method according to some embodiment of this application;
FIG. 10 is a schematic diagram of prompt information being image information according to some embodiment of this application;
FIG. 11 is another schematic diagram of prompt information being image information according to some embodiment of this application;
FIG. 12 is a schematic structural diagram of a battery leakage current check apparatus according to some embodiment of this application;
FIG. 13 is a schematic structural diagram of another battery leakage current check apparatus according to some embodiment of this application; and
FIG. 14 is a schematic structural diagram of still another battery leakage current check apparatus according to some embodiment of this application.

### DESCRIPTION OF EMBODIMENTS

The following describes the embodiments of this application with reference to the accompanying drawings.

A leakage current described in the embodiments of this application indicates self discharge performed by a battery that is in a natural placement state and that is not connected to an external power consumption circuit. As time elapses, a voltage difference between a positive electrode and a negative electrode of the battery increasingly decreases. A battery leakage current check method, apparatus, and circuit provided in the embodiments of this application are used to determine whether leakage current is serious by using a voltage drop between a positive electrode and a negative electrode of a battery.

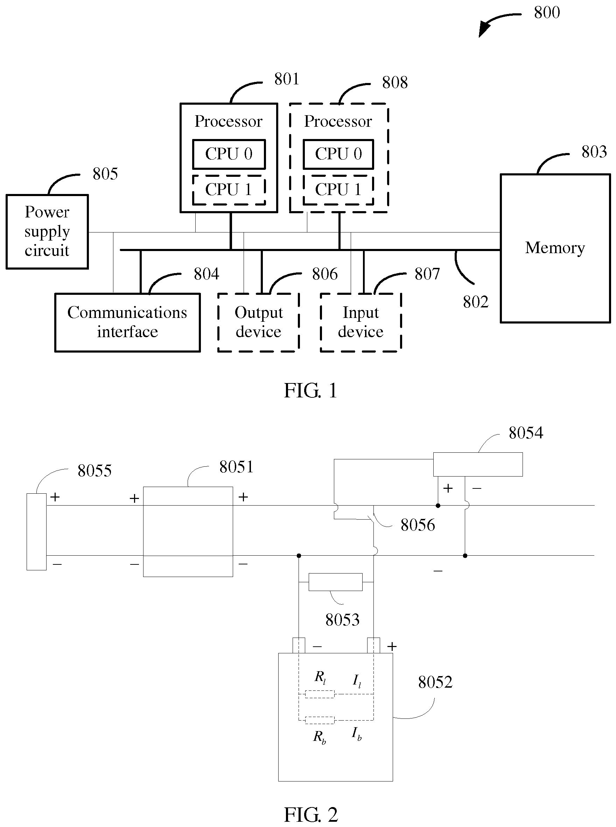

As shown in FIG. 1, FIG. 1 is a schematic structural diagram of hardware of an electronic device 800 according to some embodiment of this application. The electronic device 800 includes at least one processor 801, a communications bus 802, a memory 803, at least one communications interface 804, and a battery leakage current check circuit 805.

The processor 801 may be a general-purpose central processing unit (central processing unit, CPU), a microprocessor, an application-specific integrated circuit (application-specific integrated circuit, ASIC), or one or more integrated circuits configured to control program execution of the solution in this application.

The communications bus 802 may include a path on which information is transmitted between the foregoing components.

The memory 803 may be a read-only memory (read-only memory, ROM) or another type of static storage device that may store static information and instructions, a random access memory (random access memory, RAM) or another type of dynamic storage device that may store information and instructions; or may be an electrically erasable programmable read-only memory (electrically erasable programmable read-only memory, EEPROM), a compact disc read-only memory (compact disc read-only memory, CD-ROM) or other compact disc storage, optical disc storage (including a compact disc, a laser disc, an optical disc, a digital versatile disc, a Blu-ray disc, and the like), a magnetic disk storage medium or another magnetic storage device, or any other medium that can be used to carry or store expected program code that has an instruction or data structure form and that can be accessed by a computer. However, this is not limited herein. The memory may be a separate memory and is connected to the processor by using the bus, or the memory may be integrated with the processor.

The memory 803 is configured to store application program code that executes the solution in this application, and the processor 801 controls execution of the solution in this application. The processor 801 is configured to execute the application program code stored in the memory 803, so as to implement the battery leakage current check method.

The communications interface 804, which uses any apparatus such as a transceiver, is configured to communicate with another device or communications network, such as Ethernet, a radio access network (radio access network, RAN), or a wireless local area network (wireless local area networks, WLAN).

The battery leakage current check circuit 805 includes a power source such as a battery, which is configured to provide a normal working voltage for load of the electronic device 800.

In specific implementation, in some embodiment, the processor 801 may include one or more CPUs, such as a CPU 0 and a CPU 1 in FIG. 1.

In specific implementation, in some embodiment, the electronic device 800 may include a plurality of processors, such as a processor 801 and a processor 808 in FIG. 1. Each of these processors may be a single-core (single-CPU) processor or a multi-core (multi-CPU) processor. The processor herein may be one or more devices, circuits, and/or processing cores configured to process data (for example, a computer program instruction).

In specific implementation, in some embodiment, the electronic device 800 may further include an output device 806 and an input device 807. The output device 806 communicates with the processor 801, and may display information in a plurality of manners. For example, the output device 806 may be a liquid crystal display (liquid crystal display, LCD), a light emitting diode (light emitting diode, LED) display device, a cathode ray tube (cathode ray tube, CRT) display device, a projector (projector), or the like. The input device 807 communicates with the processor 801, and may receive input of a user in a plurality of manners. For example, the input device 807 may be a mouse, a keyboard, a touchscreen device, a sensor device, or the like.

The electronic device 800 may be a general-purpose electronic device or a dedicated electronic device. In specific implementation, the electronic device 800 may be a desktop computer, a portable computer, a network server, a personal digital assistant (personal digital assistant, PDA), a mobile phone, a tablet computer, a wireless terminal device, a communications device, an embedded device, or a device with a structure similar to that in FIG. 1. A type of the electronic device 800 is not limited in this embodiment of this application.

Referring to FIG. 2, some embodiment of this application provides a battery leakage current check circuit. The circuit includes a charging chip 8051, a battery 8052, an electricity meter 8053, a controller 8054, a power adapter 8055, and a first switch 8056.

The electricity meter 8053 is electrically connected to the battery 8052 and the controller 8054. The electricity meter 8053 is configured to: obtain a voltage of the battery 8052, and send the obtained battery voltage to the controller 8054.

The charging chip 8051 is electrically connected to load (not shown in the figure) of an electronic device, and the charging chip 8051 is electrically connected to the battery 8052. The charging chip 8051 is configured to receive power supply from the power adapter 8055, so as to supply power to the load and charge the battery 8052 at the same time.

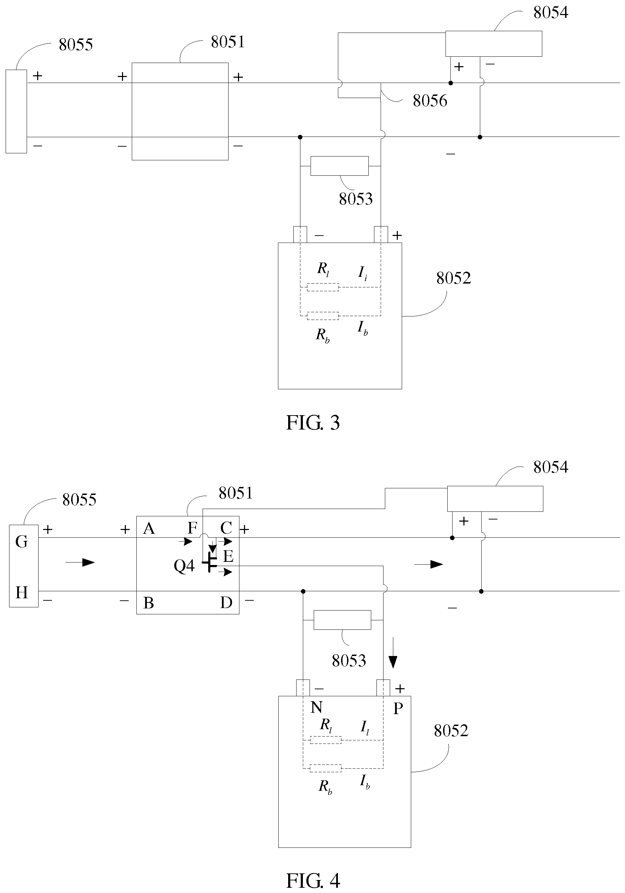

The first switch 8056 is electrically connected to the charging chip 8051, the battery 8052, and the load. Referring to FIG. 2, when the first switch 8056 is turned off, the battery 8052 is electrically disconnected from the charging chip 8051 and the load. Referring to FIG. 3, when the first switch 8056 is turned on, the battery 8052 is electrically connected to the charging chip 8051 and the load. When the power adapter 8055 is electrically disconnected from the charging chip 8051, the battery 8052 is enabled to electrically connect to the load of the electronic device, so that the battery 8052 supplies power to the load of the electronic device. When the power adapter 8055 is electrically connected to the charging chip 8051, the power adapter 8055 may use the charging chip 8051 to supply power to the load of the electronic device and charge the battery 8052 at the same time.

FIG. 2 and FIG. 3 further show an equivalent battery internal resistance *R_{b}* and a leakage current resistance *Rₜ*. The internal resistance *R_{b}* is used to indicate that when the battery 8052 is charged or discharges, heat is generated and specific electrical energy is consumed; and the battery 8052 is equivalent to a resistance that generates heat. A current that flows is *I_{b}.* The leakage current resistance *Rₗ* is a resistance corresponding to a generated leakage current. A current that flows is *Iₗ*.

It should be noted that, the foregoing discloses an example of the first switch 8056 according to function division only. A person skilled in the art may figure out that another switch (such as a metal oxide semiconductor (metal oxide semiconductor, MOS) transistor) having a similar function is also applicable to the protection scope of this application.

For example, referring to FIG. 4, FIG. 4 is a schematic diagram of an example of a battery leakage current check circuit 805. The battery leakage current check circuit includes a charging chip 8051, a battery 8052, an electricity meter 8053, a controller 8054, and a power adapter 8055. The charging chip 8051 includes a charging positive voltage pin A, a charging ground pin B, a power supply positive voltage pin C, a power supply ground pin D, a battery pin E, and a control pin F. The battery 8052 includes a positive electrode P and a negative electrode N.

A MOS transistor switch Q4 (the MOS transistor switch Q4 herein is equivalent to the first switch 8056) is built in the charging chip 8051. A gate electrode of the MOS transistor switch Q4 is electrically connected to a control end of the controller 8054 by using the control pin F. A source electrode of the MOS transistor switch Q4 is electrically connected to the positive electrode P of the battery 8052 by using the battery pin E. A drain electrode of the MOS transistor switch Q4 is electrically connected to the charging positive voltage pin A and the power supply positive voltage pin C. The charging positive voltage pin A of the charging chip 8051 is electrically connected to a positive voltage output end G of the power adapter 8055, the charging ground pin B of the charging chip 8051 is electrically connected to a ground output end H of the power adapter 8055, and the charging ground pin B is electrically connected to the power supply ground pin D. The power supply positive voltage pin C and the power supply ground pin D of the charging chip 8051 are electrically connected to load (not shown in the figure) inside an electronic device to supply power to the load.

When the controller 8054 provides a high level for the gate electrode of the MOS transistor switch Q4, the drain electrode and the source electrode of the MOS transistor switch Q4 are conducted, so that the battery 8052 and the charging chip 8051 are electrically connected. Referring to FIG. 4, when the power adapter 8055 is connected to the charging positive voltage pin A and the charging ground pin B, the power adapter 8055 supplies power to the charging chip 8051. After transferring the power, the charging chip 8051 may supply power to the load inside the electronic device, and may charge the battery 8052 by using the battery pin E and the power supply ground pin D at the same time. An arrow in the figure is a current direction.

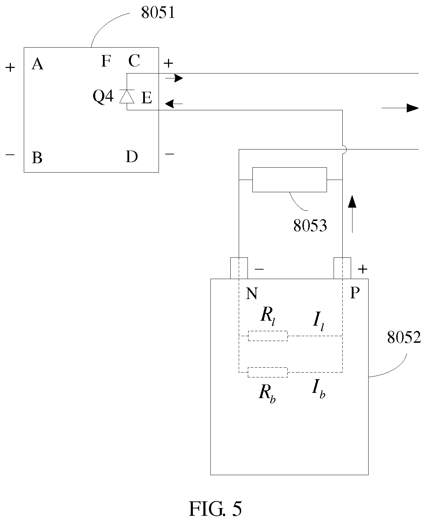

Referring to FIG. 5, when the power adapter is disconnected from the pin A and the charging ground pin B, the MOS transistor switch Q4 is equivalent to a diode. Because a voltage of the positive electrode P of the battery 8052 is greater than a cutoff voltage of the diode, the diode is automatically conducted, so that the power supply positive voltage pin C and the battery pin E are conducted, and the battery 8052 supplies power to the load inside the electronic device, so as to implement seamless power supply switching. An arrow in the figure is a current direction. It should be noted that, the drain electrode and the source electrode of the MOS transistor switch Q4 are conducted because a forward voltage is greater than a cutoff voltage, and therefore there is still a relatively large current loss on the MOS transistor switch Q4 during power supply switching. The controller 8054 needs to provide a high level for the gate electrode of the MOS transistor switch Q4 again, and then the source electrode and the drain electrode of the MOS transistor switch Q4 are naturally conducted. In this case, there is a relatively small current loss on the MOS transistor switch Q4.

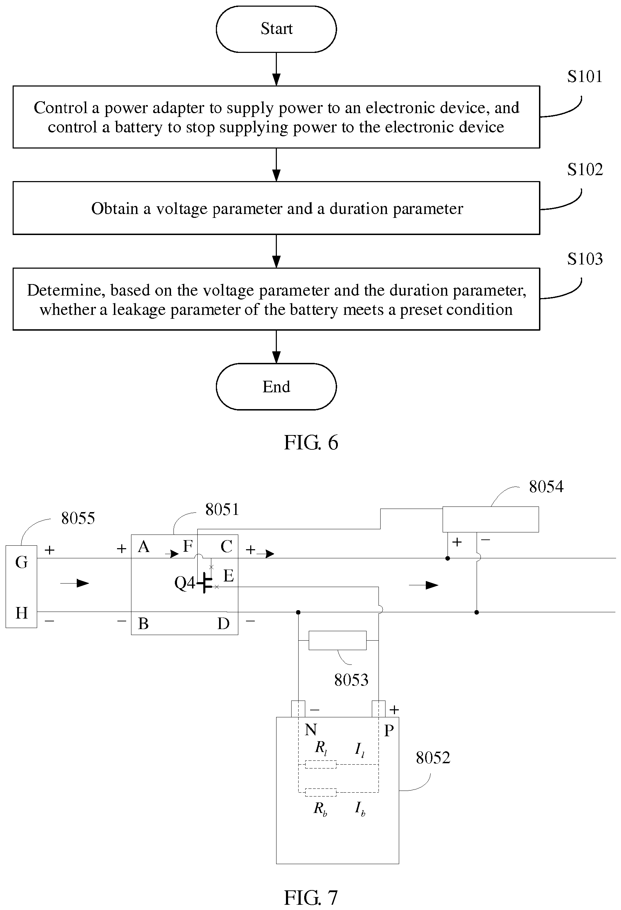

Some embodiment of this application provides a battery leakage current check method, which may be performed by the controller 8054 described above. Referring to FIG. 6, the method includes steps S101 to S103.

S101. Control a power adapter to supply power to an electronic device, and control a battery to stop supplying power to the electronic device.

To prevent the electronic device from being shut down because of power failure, a power adapter 8055 needs to supply power to load of the electronic device by using a charging chip 8051. In addition, a battery 8052 needs to be electrically disconnected from the charging chip 8051 and the load, so as to electrically disconnect the battery 8052 from the power adapter 8055 and the load of the electronic device, so that the battery is in a natural unloaded state. Referring to FIG. 2, the controller 8054 controls a first switch 8056 to be turned off. Alternatively, referring to FIG. 7, the controller 8054 outputs a low level to a gate electrode of a MOS transistor switch Q4, so that a drain electrode and a source electrode of the MOS transistor switch Q4 are cut off. An arrow in the figure is a current direction.

It should be noted that a condition for triggering battery leakage current check includes but is not limited to: after battery charging is completed and the battery is full of electricity, or during battery charging; when it is determined that the electronic device enters a standby state if a user has no operation at a current time or for a long time; when the power adapter is connected to the electronic device and supplies power to the electronic device; when a user enters, by using a user interface (user interface, UI), a command to start to perform battery leakage current check; or at periodic intervals, such as a week, a month, or a year.

When the battery is full of electricity, a voltage difference between a positive electrode and a negative electrode of the battery may theoretically reach a rated voltage of the battery, such as 4.2 V or 4.35 V. However, because all batteries have self discharge at different degrees, and discharge of a battery increases as time passes, a voltage difference between a positive electrode and a negative electrode of the battery decreases. As a result, a rated voltage of the battery cannot be reached.

S102. Obtain a voltage parameter and a duration parameter, where the voltage parameter is a difference between voltages of the battery at two different moments, and the duration parameter is duration between the two different moments.

For example, a first voltage of the battery 8052 may be measured at a first moment by using an electricity meter 8053, and a second voltage of the battery 8052 may be measured at a second moment by using the electricity meter 8053. In this case, the voltage parameter is a difference between the first voltage and the second voltage, and the duration parameter is duration from the first moment to the second moment. In other words, the duration parameter is a time difference between the first moment and the second moment. Alternatively, for example, the voltage parameter and the duration parameter may be directly obtained.

S103. Determine, based on the voltage parameter and the duration parameter, whether a leakage parameter of the battery meets a preset condition.

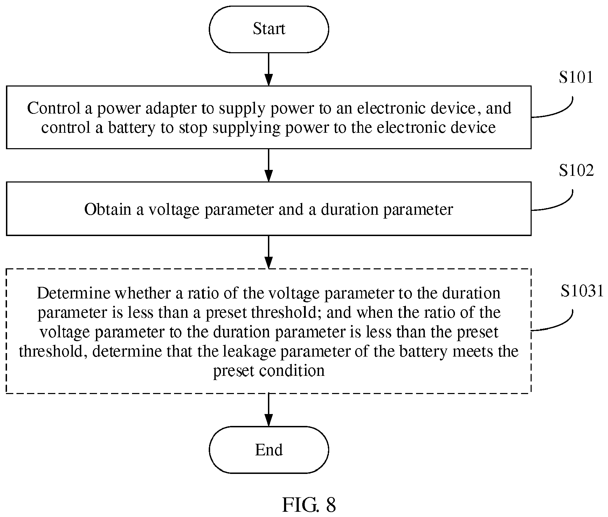

That a leakage parameter of the battery meets a preset condition means that a leakage current in the battery is relatively low, that is, within a normal range. In this case, the battery works in a normal state. That a leakage parameter of the battery does not meet a preset condition means that a leakage current in the battery is relatively high, that is, beyond a normal range. In this case, the battery works in an abnormal state. If the leakage current inside the battery is relatively high, correspondingly, a time required for a unit voltage drop of the battery is less than a preset threshold, or a voltage drop of the battery within a unit time exceeds a preset threshold. Therefore, referring to FIG. 8, step S103 may specifically include step S1031:

S1031. Determine whether a ratio of the voltage parameter to the duration parameter is less than a preset threshold; and when the ratio of the voltage parameter to the duration parameter is less than the preset threshold, determine that the leakage parameter of the battery meets the preset condition.

The preset threshold may be set based on an actual situation.

For example, it is assumed that the preset threshold is 10 mV/hour (when a current of about 30 mA is consumed, a corresponding leakage current is about 30 mA). When battery charging is completed (at the first moment), a voltage between the positive electrode and the negative electrode of the battery is measured to obtain the first voltage. An hour later (at the second moment), a voltage between the positive electrode and the negative electrode of the battery is measured to obtain the second voltage. In this case, the voltage parameter is equal to the first voltage minus the second voltage, and the duration parameter is one hour. It is determined whether the ratio of the voltage parameter to the duration parameter is less than the preset threshold. When the ratio of the voltage parameter to the duration parameter is less than 10 mV/hour, it is determined that the leakage parameter of the battery meets the preset condition, and the battery works normally. When the ratio of the voltage parameter to the duration parameter is greater than 10 mV/hour, it is determined that the leakage current in the battery is relatively high, the leakage parameter of the battery does not meet the preset condition, and the battery works abnormally.

According to the battery leakage current check method provided in this embodiment of this application, when the battery stops supplying external power, and no power adapter is connected, it is determined, based on the voltage drop of the battery within the unit time or duration of the unit voltage drop, whether the leakage parameter of the battery meets the preset condition, to check for the leakage current in the battery and prevent the battery from being faulty, for example, catching fire, due to an excessively high leakage current.

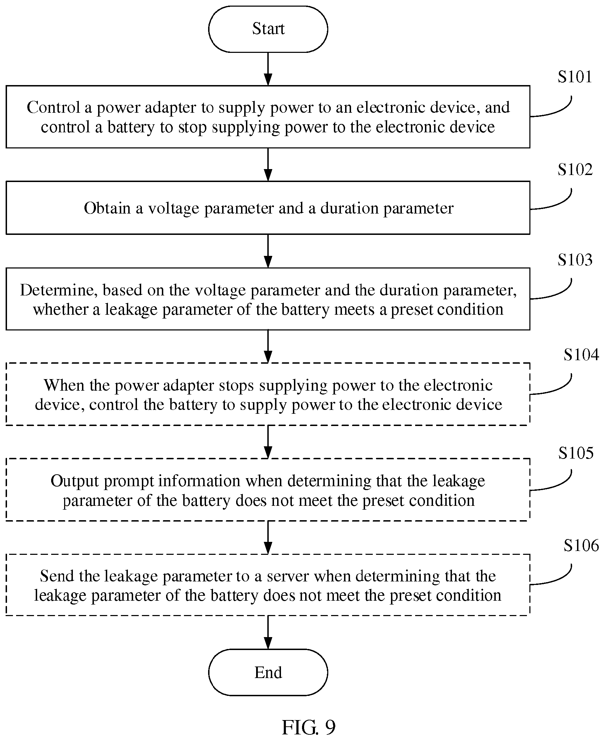

Some embodiment of this application provides another battery leakage current check method. Optionally, referring to FIG. 9, the method further includes step S104:

S104. When the power adapter stops supplying power to the electronic device, supply power to the electronic device by using the battery.

Likewise, this step may ensure uninterrupted power supply to the electronic device. For details, refer to the description of the implementation in which the battery 8052 supplies power to the load of the electronic device in FIG. 3 and FIG. 5. Details are not repeatedly described herein. It should be noted that step S104 may occur at any time in steps S101 to S103. In addition, battery leakage current check may be stopped or continue, except that a check result is not used to determine whether the leakage parameter of the battery meets the preset condition.

Optionally, referring to FIG. 9, the method may further include step S105:

S105. Output prompt information when determining that the leakage parameter of the battery does not meet the preset condition.

Optionally, the prompt information includes at least one of the following information: sound information, text information, image information, vibration information, light information, and the like. For example, a display may be instructed to output the text information, the image information, the light information, and the like. A headset, an earpiece, a loudspeaker, and the like may be instructed to output the sound information. A vibration motor may be instructed to output the vibration information. In addition, when the prompt information is the image information, the text information, the light information, and the like, the prompt information may be displayed in a blinking manner to further emphasize an emergency degree. In this way, it is convenient to prompt a user in time that the battery may be faulty, so as to ensure use safety by avoiding a fault such as battery fire.

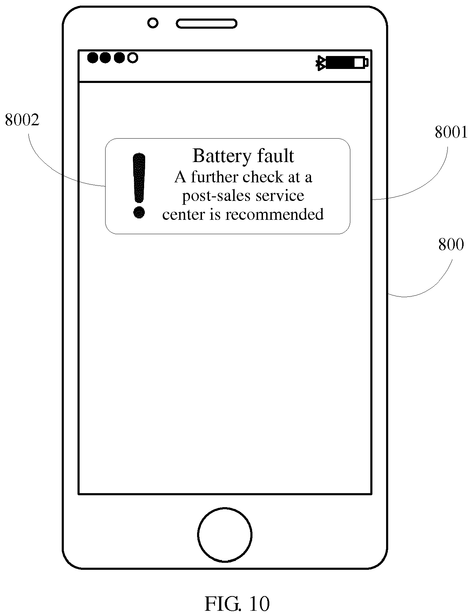

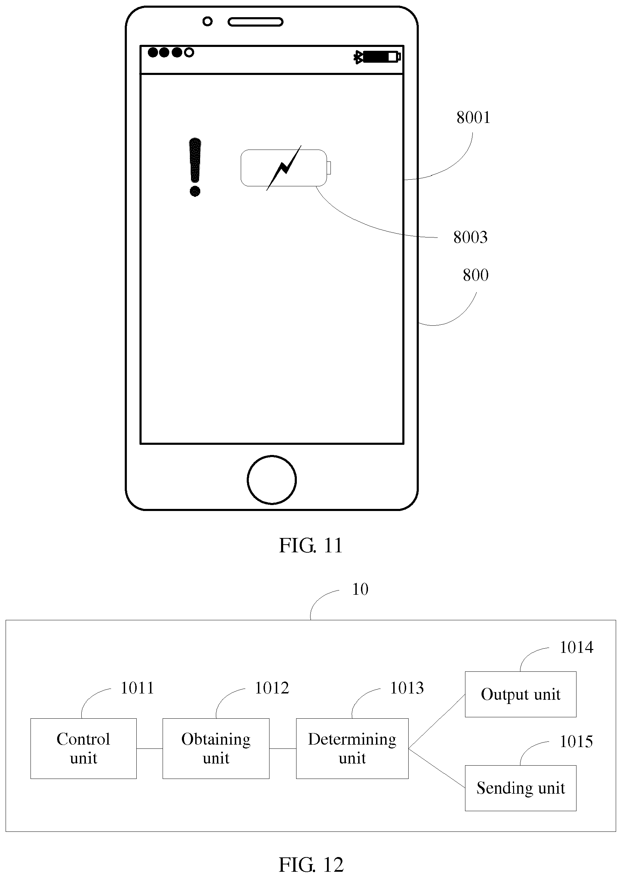

For example, referring to FIG. 10, FIG. 10 shows an example in which the prompt information is image information. A text 8002 is displayed on a display screen 8001 of an electronic device 800, for example, "Battery fault! A further check at a post-sales service center is recommended" may be notified. Referring to FIG. 11, FIG. 11 shows another example in which the prompt information is image information. A battery image 8003 may be displayed on a display screen 8001 of an electronic device 800. In addition, different from a normal battery state during charging, the battery may be displayed in an alarm color such as red. A person skilled in the art may further figure out other image information, and details are not described herein.

Optionally, referring to FIG. 9, the method may further include step S106:

S106. Send the leakage parameter to a server when determining that the leakage parameter of the battery does not meet the preset condition.

The collected leakage parameter may be uploaded in a wired or wireless manner, and the used communication means includes but is not limited to Wireless Fidelity (Wireless-Fidelity, WiFi), Bluetooth (Bluetooth, BT), an infrared ray, a laser, a sound wave, the ZigBee (ZigBee) protocol, and the like. In this way, it may be convenient for a manufacturer of the electronic device to collect fault information of the electronic device, so as to analyze a fault cause and improve product performance.

It should be noted that there is no execution sequence between steps S105 and S106.

Some embodiment of this application provides a battery leakage current check apparatus, configured to perform the foregoing battery leakage current check method. In this embodiment of this application, the battery leakage current check apparatus may be divided into function modules according to the method examples. For example, various function modules corresponding to various functions may be obtained through division, or two or more functions may be integrated into one processing module. The integrated module may be implemented in a form of hardware, or may be implemented in a form of a software functional module. It should be noted that, the module division in this embodiment of this application is an example, is merely logical function division, and may be another division manner in actual implementation.

When various function modules corresponding to various functions are obtained through division, FIG. 12 shows a possible schematic structural diagram of the battery leakage current check apparatus in the foregoing embodiments. A battery leakage current check apparatus 10 includes a control unit 1011, an obtaining unit 1012, a determining unit 1013, an output unit 1014, and a sending unit 1015. The control unit 1011 is configured to support the battery leakage current check apparatus 10 to perform process S101 in FIG. 6, process S101 in FIG. 8, and processes S101 and S104 in FIG. 9. The obtaining unit 1012 is configured to support the battery leakage current check apparatus 10 to perform process S102 in FIG. 6, process S102 in FIG. 8, and process S102 in FIG. 9. The determining unit 1013 is configured to support the battery leakage current check apparatus 10 to perform process S103 in FIG. 6, process S1031 in FIG. 8, and process S103 in FIG. 9. The output unit 1014 is configured to support the battery leakage current check apparatus 10 to perform process S105 in FIG. 9. The sending unit 1015 is configured to support the battery leakage current check apparatus 10 to perform process S106 in FIG. 9. All the related content of the steps used in the method embodiments may be cited in function descriptions of corresponding function modules, and details are not repeatedly described herein.

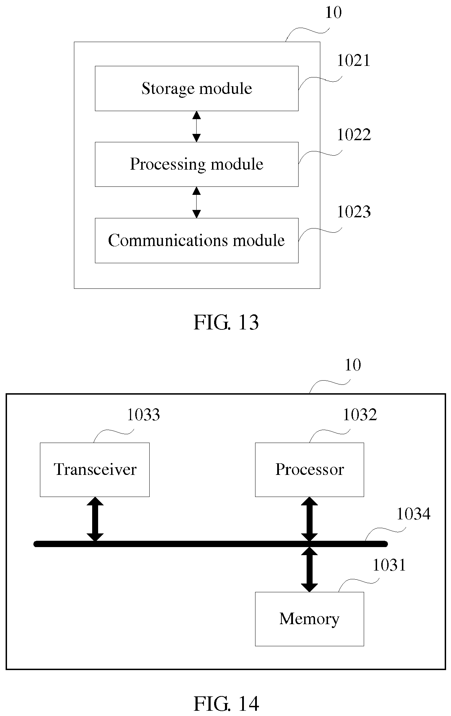

When an integrated unit is used, FIG. 13 shows a possible schematic structural diagram of the battery leakage current check apparatus in the foregoing embodiments. A battery leakage current check apparatus 10 includes a processing module 1022 and a communications module 1023. The processing module 1022 is configured to control and manage an action of the battery leakage current check apparatus 10. For example, the processing module 1022 is configured to support the battery leakage current check apparatus 10 to perform processes S101 to S103 in FIG. 6, processes S101 to S1031 in FIG. 8, and processes S101 to S106 in FIG. 9. The communications module 1023 is configured to support communication between the battery leakage current check apparatus and another entity, for example, communication with a function module or a network entity shown in FIG. 6. The battery leakage current check apparatus 10 may further include a storage module 1021, configured to store program code and data of the battery leakage current check apparatus.

The processing module 1022 may be a processor or a controller, for example, may be a central processing unit (central processing unit, CPU), a general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The processing module 1022 may implement or execute various examples of logical blocks, modules, and circuits that are described with reference to content disclosed in this application. Alternatively, the processor may be a combination of processors implementing a computing function, for example, a combination of one or more microprocessors, or a combination of a DSP and a microprocessor. The communications module 1023 may be a transceiver, a transceiver circuit, a communications interface, or the like. The storage module 1021 may be a memory.

When the processing module 1022 is a processor, the communications module 1023 is a transceiver, and the storage module 1021 is a memory, the battery leakage current check apparatus in this embodiment of this application may be a battery leakage current check apparatus 10 described below.

Referring to FIG. 14, the battery leakage current check apparatus 10 includes a processor 1032, a transceiver 1033, a memory 1031, and a bus 1034. The transceiver 1033, the processor 1032, and the memory 1031 are interconnected by using the bus 1034. The bus 1034 may be a peripheral component interconnect (peripheral component interconnect, PCI) bus, an extended industry standard architecture (extended industry standard architecture, EISA) bus, or the like. The bus may be classified into an address bus, a data bus, a control bus, and the like. For ease of representation, only one thick line is used to represent the bus in the figure, but this does not mean that there is only one bus or only one type of bus.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A battery leakage current check method, wherein a battery is installed in an electronic device and is configured to supply power to the electronic device, and the method comprises:
controlling (S101), by the electronic device, the battery to stop supplying power to the electronic device when a power adapter supplies power to the electronic device;
after controlling (S101) the battery to stop supplying power to the electronic device, obtaining (S102), by the electronic device, a voltage parameter and a time duration parameter, wherein the voltage parameter is a difference between voltages of the battery at two different time moments, and the time duration parameter is a duration between the two different time moments; and
determining (S103), by the electronic device, based on the voltage parameter and the time duration parameter, whether a leakage parameter of the battery meets a preset condition to check for a leakage current in the battery, wherein the leakage parameter of the battery meets the preset condition indicates that a leakage current in the battery is within a normal range;
wherein the determining (S103) whether the leakage parameter of the battery meets the preset condition comprises:
determining (S1031), by the electronic device, whether a ratio of the voltage parameter to the time duration parameter is less than a preset threshold; and
determining, by the electronic device, that the leakage parameter of the battery meets the preset condition when the ratio of the voltage parameter to the time duration parameter is less than the preset threshold.

2. The method according to claim 1, wherein the method further comprises:
controlling (S104), by the electronic device, the batter to supply power to the electronic device when the power adapter stops supplying power to the electronic device.

3. The method according to claim 1 or 2, wherein the method further comprises:
outputting (S105), by the electronic device, prompt information when determining that the leakage parameter of the battery does not meet the preset condition.

4. The method according to claim 3, wherein the prompt information comprises at least one of the following information: sound information, text information, image information, vibration information, or light information.

5. The method according to any one of claims 1 to 4, wherein the method further comprises:
sending (S106), by the electronic device, the leakage parameter to a server when determining that the leakage parameter of the battery does not meet the preset condition.

6. A battery leakage current check apparatus (10), wherein a battery is installed in an electronic device and is configured to supply power to the electronic device, and the battery leakage current check apparatus comprises:
a control unit (1011), configured to: control the battery to stop supplying power to the electronic device when a power adapter supplies power to the electronic device;
an obtaining unit (1012), configured to obtain a voltage parameter and a time duration parameter after the control unit (1011) controls the battery to stop supplying power to the electronic device, wherein the voltage parameter is a difference between voltages of the battery at two different time moments, and the time duration parameter is a duration between the two different time moments; and
a determining unit (1013), configured to determine, based on the voltage parameter and the time duration parameter, whether a leakage parameter of the battery meets a preset condition to check for a leakage current in the battery, wherein the leakage parameter of the battery meets the preset condition indicates that a leakage current in the battery is within a normal range;
wherein the determining unit (1013) is specifically configured to:
determine whether a ratio of the voltage parameter to the time duration parameter is less than a preset threshold; and
determine that the leakage parameter of the battery meets the preset condition when the ratio of the voltage parameter to the time duration parameter is less than the preset threshold.

7. The apparatus according to claim 6, wherein the control unit (1011) is further configured to:
control the battery to supply power to the electronic device when the power adapter stops supplying power to the electronic device.

8. The apparatus according to claim 6 or 7, wherein the apparatus further comprises:
an output unit (1014), configured to output prompt information when the leakage parameter of the battery does not meet the preset condition.

9. The apparatus according to claim 8, wherein the prompt information comprises at least one of the following information: sound information, text information, image information, vibration information, or light information.

10. The apparatus according to any one of claims 6 to 9, wherein the apparatus further comprises:
a sending unit (1015), configured to send the leakage parameter to a server when the leakage parameter of the battery does not meet the preset condition.

11. A computer program product comprising an instruction, wherein when the computer program product runs on a battery leakage current check apparatus according to any one of claims 6 to 10, the battery leakage current check apparatus performs the battery leakage current check method according to any one of claims 1 to 5.

## Patentansprüche

1. Prüfverfahren für Batterieleckstrom, wobei eine Batterie in einer elektronischen Vorrichtung installiert und konfiguriert ist, um Leistung an die elektronische Vorrichtung zu liefern, und das Verfahren umfasst:
Steuern (S101), durch die elektronische Vorrichtung, der Batterie, um das Liefern von Leistung an die elektronische Vorrichtung zu beenden, wenn ein Netzteil Leistung an die elektronische Vorrichtung liefert;
nach dem Steuern (S101) der Batterie, um das Liefern von Leistung an die elektronische Vorrichtung zu beenden, Erhalten (S102), durch die elektronische Vorrichtung, eines Spannungsparameters und eines Zeitdauerparameters, wobei der Spannungsparameter eine Differenz zwischen Spannungen der Batterie an zwei verschiedenen Zeitpunkten ist und der Zeitdauerparameter eine Dauer zwischen den zwei verschiedenen Zeitpunkten ist; und
Bestimmen (S103), durch die elektronische Vorrichtung, basierend auf dem Spannungsparameter und dem Zeitdauerparameter, ob ein Leckparameter der Batterie eine voreingestellte Bedingung erfüllt, um auf einen Leckstrom in der Batterie zu prüfen, wobei der Leckparameter der Batterie, der die voreingestellte Bedingung erfüllt, anzeigt, dass ein Leckstrom in der Batterie innerhalb eines normalen Bereichs liegt;
wobei das Bestimmen (S103), ob der Leckparameter der Batterie die voreingestellte Bedingung erfüllt, umfasst:
Bestimmen (S1031), durch die elektronische Vorrichtung, ob ein Verhältnis des Spannungsparameters zu dem Zeitdauerparameter kleiner als ein voreingestellter Schwellenwert ist; und
Bestimmen, durch die elektronische Vorrichtung, dass der Leckparameter der Batterie die voreingestellte Bedingung erfüllt, wenn das Verhältnis des Spannungsparameters zu dem Zeitdauerparameter kleiner als der voreingestellte Schwellenwert ist.

2. Verfahren nach Anspruch 1, wobei das Verfahren ferner umfasst:
Steuern (S104), durch die elektronische Vorrichtung, der Batterie, um Leistung an die elektronische Vorrichtung zu liefern, wenn das Netzteil das Liefern von Leistung an die elektronische Vorrichtung beendet.

3. Verfahren nach Anspruch 1 oder 2, wobei das Verfahren ferner umfasst:
Ausgeben (S105), durch die elektronische Vorrichtung, von Aufforderungsinformationen, wenn bestimmt wird, dass der Leckparameter der Batterie die voreingestellte Bedingung nicht erfüllt.

4. Verfahren nach Anspruch 3, wobei die Aufforderungsinformationen mindestens eine der folgenden Informationen umfassen: Toninformationen, Textinformationen, Bildinformationen, Schwingungsinformationen oder Lichtinformationen.

5. Verfahren nach einem der Ansprüche 1 bis 4, wobei das Verfahren ferner umfasst:
Senden (S106), durch die elektronische Vorrichtung, des Leckparameters an einen Server, wenn bestimmt wird, dass der Leckparameter der Batterie die voreingestellte Bedingung nicht erfüllt.

6. Prüfeinrichtung (10) für Batterieleckstrom, wobei eine Batterie in einer elektronischen Vorrichtung installiert und konfiguriert ist, um Leistung an die elektronische Vorrichtung zu liefern, und wobei die Prüfeinrichtung für Batterieleckstrom umfasst:
eine Steuereinheit (1011), die konfiguriert ist um: die Batterie zu steuern, um das Liefern von Leistung an die elektronische Vorrichtung zu beenden, wenn ein Netzteil Leistung an die elektronische Vorrichtung liefert;
eine Erhaltungseinheit (1012), die konfiguriert ist, um einen Spannungsparameter und einen Zeitdauerparameter zu erhalten, nachdem die Steuereinheit (1011) die Batterie steuert, um das Liefern von Leistung an die elektronische Vorrichtung zu beenden, wobei der Spannungsparameter eine Differenz zwischen Spannungen der Batterie an zwei verschiedenen Zeitpunkten ist und der Zeitdauerparameter eine Dauer zwischen den zwei verschiedenen Zeitpunkten ist; und
eine Bestimmungseinheit (1013), die konfiguriert ist, um basierend auf dem Spannungsparameter und dem Zeitdauerparameter zu bestimmen, ob ein Leckparameter der Batterie eine voreingestellte Bedingung erfüllt, um auf einen Leckstrom in der Batterie zu prüfen, wobei der Leckparameter der Batterie, der die voreingestellte Bedingung erfüllt, anzeigt, dass ein Leckstrom in der Batterie innerhalb eines normalen Bereichs liegt;
wobei die Bestimmungseinheit (1013) speziell konfiguriert ist, um:
zu bestimmen, ob ein Verhältnis des Spannungsparameters zu dem Zeitdauerparameter kleiner als ein voreingestellter Schwellenwert ist; und
zu bestimmen, dass der Leckparameter der Batterie die voreingestellte Bedingung erfüllt, wenn das Verhältnis des Spannungsparameters zu dem Zeitdauerparameter kleiner als der voreingestellte Schwellenwert ist.

7. Einrichtung nach Anspruch 6, wobei die Steuereinheit (1011) ferner konfiguriert ist, um:
die Batterie zu steuern, um Leistung an die elektronische Vorrichtung zu liefern, wenn das Netzteil das Liefern von Leistung an die elektronische Vorrichtung beendet.

8. Einrichtung nach Anspruch 6 oder 7, wobei die Einrichtung ferner umfasst:
eine Ausgabeeinheit (1014), die konfiguriert ist, um Aufforderungsinformationen auszugeben, wenn der Leckparameter der Batterie die voreingestellte Bedingung nicht erfüllt.

9. Einrichtung nach Anspruch 8, wobei die Aufforderungsinformationen mindestens eine der folgenden Informationen umfassen: Toninformationen, Textinformationen, Bildinformationen, Schwingungsinformationen oder Lichtinformationen.

10. Einrichtung nach einem der Ansprüche 6 bis 9, wobei die Einrichtung ferner umfasst:
eine Sendeeinheit (1015), die konfiguriert ist, um den Leckparameter an einen Server zu senden, wenn der Leckparameter der Batterie die voreingestellte Bedingung nicht erfüllt.

11. Computerprogrammprodukt, umfassend eine Anweisung, wobei, wenn das Computerprogrammprodukt auf einer Prüfeinrichtung für Batterieleckstrom nach einem der Ansprüche 6 bis 10 läuft, die Prüfeinrichtung für Batterieleckstrom das Prüfverfahren für Batterieleckstrom nach einem der Ansprüche 1 bis 5 durchführt.

## Revendications

1. Procédé de vérification de courant de fuite de batterie, dans lequel une batterie est installée dans un dispositif électronique et est configurée pour fournir de l'énergie au dispositif électronique, et le procédé comprend :
la commande (S101), par le dispositif électronique, de la batterie pour arrêter la fourniture d'énergie au dispositif électronique lorsqu'un adaptateur d'alimentation fournit de l'énergie au dispositif électronique ;
après la commande (S101) de la batterie pour arrêter la fourniture d'énergie au dispositif électronique, l'obtention (S102), par le dispositif électronique, d'un paramètre de tension et d'un paramètre de durée de temps, dans lequel le paramètre de tension est une différence entre les tensions de la batterie à deux moments de temps différents, et le paramètre de durée de temps est une durée entre les deux moments de temps différents ; et
la détermination (S103), par le dispositif électronique, en fonction du paramètre de tension et du paramètre de durée de temps, du fait de savoir si un paramètre de fuite de la batterie remplit une condition prédéfinie pour vérifier un courant de fuite dans la batterie, dans lequel le paramètre de fuite de la batterie remplit la condition prédéfinie indique qu'un courant de fuite dans la batterie se situe dans une plage normale ;
dans lequel la détermination (S103) du fait de savoir si le paramètre de fuite de la batterie satisfait à la condition prédéfinie comprend :
la détermination (S1031), par le dispositif électronique, du fait de savoir si un rapport du paramètre de tension au paramètre de durée de temps est inférieur à un seuil prédéfini ; et
la détermination, par le dispositif électronique, du fait que le paramètre de fuite de la batterie remplit la condition prédéfinie lorsque le rapport du paramètre de tension au paramètre de durée de temps est inférieur au seuil prédéfini.

2. Procédé selon la revendication 1, le procédé comprenant en outre :
la commande (S104), par le dispositif électronique, de la batterie pour fournir de l'énergie au dispositif électronique lorsque l'adaptateur d'alimentation arrête la fourniture d'énergie au dispositif électronique.

3. Procédé selon la revendication 1 ou 2, dans lequel le procédé comprend en outre :
l'émission (S105), par le dispositif électronique, d'informations d'invite lors de la détermination du fait que le paramètre de fuite de la batterie ne remplit pas la condition prédéfinie.

4. Procédé selon la revendication 3, dans lequel les informations d'invite comprennent au moins l'une des informations suivantes : des informations sonores, des informations textuelles, des informations d'image, des informations de vibration ou des informations de lumière.

5. Procédé selon l'une quelconque des revendications 1 à 4, dans lequel le procédé comprend en outre :
l'envoi (S106), par le dispositif électronique, du paramètre de fuite à un serveur lors de la détermination du fait que le paramètre de fuite de la batterie ne remplit pas la condition prédéfinie.

6. Appareil de vérification de courant de fuite de batterie (10), dans lequel une batterie est installée dans un dispositif électronique et est configurée pour fournir de l'énergie au dispositif électronique, et l'appareil de vérification de courant de fuite de batterie comprend :
une unité de commande (1011), configurée pour : commander la batterie pour arrêter la fourniture d'énergie au dispositif électronique lorsqu'un adaptateur d'alimentation fournit de l'énergie au dispositif électronique ;
une unité d'obtention (1012), configurée pour obtenir un paramètre de tension et un paramètre de durée de temps après la commande par l'unité de commande (1011) de la batterie pour arrêter la fourniture d'énergie au dispositif électronique, le paramètre de tension étant une différence entre les tensions de la batterie à deux moments de temps différents, et le paramètre de durée de temps est une durée entre les deux moments de temps différents ; et
une unité de détermination (1013), configurée pour déterminer, en fonction du paramètre de tension et du paramètre de durée de temps, si un paramètre de fuite de la batterie remplit une condition prédéfinie pour vérifier un courant de fuite dans la batterie, dans lequel le paramètre de fuite de la batterie satisfait à la condition prédéfinie indique qu'un courant de fuite dans la batterie se situe dans une plage normale ;
dans lequel l'unité de détermination (1013) est spécifiquement configurée pour :
déterminer si un rapport du paramètre de tension au paramètre de durée de temps est inférieur à un seuil prédéfini ; et
déterminer que le paramètre de fuite de la batterie satisfait à la condition prédéfinie lorsque le rapport du paramètre de tension au paramètre de durée de temps est inférieur au seuil prédéfini.

7. Appareil selon la revendication 6, dans lequel l'unité de commande (1011) est en outre configurée pour :
commander la batterie pour fournir de l'énergie au dispositif électronique lorsque l'adaptateur d'alimentation arrête la fourniture d'énergie au dispositif électronique.

8. Appareil selon la revendication 6 ou 7, dans lequel l'appareil comprend en outre :
une unité d'émission (1014), configurée pour émettre des informations d'invite lorsque le paramètre de fuite de la batterie ne remplit pas la condition prédéfinie.

9. Appareil selon la revendication 8, dans lequel les informations d'invite comprennent au moins l'une des informations suivantes : des informations sonores, des informations textuelles, des informations d'image, des informations de vibration ou des informations de lumière.

10. Appareil selon l'une quelconque des revendications 6 à 9, dans lequel l'appareil comprend en outre :
une unité d'envoi (1015), configurée pour envoyer le paramètre de fuite à un serveur lorsque le paramètre de fuite de la batterie ne remplit pas la condition prédéfinie.

11. Produit-programme informatique comprenant une instruction, dans lequel lorsque le produit-programme informatique fonctionne sur un appareil de vérification de courant de fuite de batterie selon l'une quelconque des revendications 6 à 10, l'appareil de vérification de courant de fuite de batterie effectue le procédé de vérification de courant de fuite de batterie selon l'une quelconque des revendications 1 à 5.
